# EUROPEAN PATENT APPLICATION

(11) **EP 1 840 990 A1**
(43) Date of publication of application: **03.10.2007**
(21) Application number: 05842270.0
(22) Date of filing: 26.12.2005
(51) Int. Cl.: H01M 6/00

(54) **ORGANIC ELECTROLUMINESCENT DEVICE**

(30) Priority: 28.12.2004 JP 2004380368
(71) Applicant: IDEMITSU KOSAN COMPANY LIMITED, Tokyo 100-0005 (JP)
(72) Inventor: KONDO, Hirofumi, 2990293 (JP); INOUE, Tetsuya, 2990293 (JP)
(74) Representative: Gille Hrabal Struck Neidlein Prop Roos
(86) International application number: PCT/JP2005/023714
(87) International publication number: WO 2006/070713

(57) **Abstract**

An organic electroluminescent device including an anode (50), a cathode (70), and one or more organic thin layers (60) comprising an emitting layer (64), interposed between the anode (50) and the cathode (70); at least one layer of the organic thin layers (60) being formed by a wet process; and the residual solvent of the layer being the detection limit (a detected partial pressure of 1.0×10⁻¹² Pa) of temperature desorption spectroscopy (TDS: measured at 80°C) or less.

## Description

### TECHNICAL FIELD

The invention relates to an organic electroluminescent device. In detail, it relates to an organic electroluminescent device of which the lifetime is enhanced by removing a residual solvent of an organic thin layer to a high degree.

### BACKGROUND

A display element having a high performance is required as the development of the information and communication industry is accelerated. Attention is paid to an organic electroluminescent device (hereinafter "electroluminescent" is abbreviated as "EL") as a next generation display element under such circumstances.
An organic EL device is a self-emission type display element which has advantages of not only a wide view angle and an excellent contrast, but also a short response time.

An organic thin layer including an emitting layer is formed by a dry process such as vacuum deposition, or a wet process such as spin coating and inkjet.
The dry process has advantages that it is unnecessary to dissolve a material constituting the organic thin layer in a solvent and it is unnecessary to remove the solvent after forming the layer. Since the vacuum deposition is a high vacuum process requiring large equipment, the vacuum deposition has disadvantages that the production cost is expensive, it cannot be applied to a large-screen substrate, and mass-production is difficult.

On the other hand, the wet process is relatively easily applied to an enlarged screen easily. However, the wet process shortens a luminous lifetime of an organic EL device produced due to a residual solvent therein.
As a technique of forming an emitting layer by a wet process, a method is disclosed in which supersonic vibration is applied to an emitting layer when drying after applying a material constituting the emitting layer (see Patent document 1, for example). This method enhances the uniformity of the emitting layer, but the removal of the solvent from the emitting layer is insufficient.

It is preferable that an organic thin layer formed be processed at as high temperatures as possible in order to shorten drying time and decrease the amount of a residual solvent. However, the drying process is conducted only at limited high temperatures since a material used deteriorates by heat, thereby leading to a long drying time.
[Patent document 1] JP-A-2003-17252

The invention was achieved in view of the above-described problems. An object of the invention is to provide an organic EL device comprising an organic thin layer produced by a wet process and having an improved luminous lifetime.

### SUMMARY OF THE INVENTION

As a result of extensive studies on the above-mentioned problems, the inventors have found that an organic thin layer constituting an organic EL device is heated with infrared radiation under ultrahigh vacuum, whereby a residual solvent in the layer can be removed to a high degree without heating at high temperatures so that the luminous lifetime of the organic EL device can be enhanced.

According to the invention, the following organic EL device and a production method thereof is provided.
1. An organic electroluminescent device comprising:
   an anode,
   a cathode, and
   one or more organic thin layers comprising an emitting layer, interposed between the anode and the cathode;
   at least one layer of the organic thin layers being formed by a wet process; and the residual solvent of the layer being the detection limit (a detected partial pressure of 1.0×10⁻¹² Pa) of temperature desorption spectroscopy (TDS: measured at 80°C) or less.
2. The organic electroluminescent device according to 1
wherein the layer formed by a wet process is a layer dried by heating with infrared radiation under ultrahigh vacuum.

3. The organic electroluminescent device according to 2 wherein the vacuum level of the ultrahigh vacuum is 10⁻⁹ Pa to 10⁻⁶ Pa, and the heating temperature with infrared radiation is equal to or less than the glass transition temperature of a material constituting the layer formed by a wet process.
4. The organic electroluminescent device according to 2
wherein the vacuum level of the ultrahigh vacuum is 10⁻⁹ Pa to 10⁻⁷ Pa, and the heating temperature with infrared radiation is less than the glass transition temperature of a material constituting the layer formed by a wet process by 10°C or more.

5. The organic electroluminescent device according to any one of 1 to 4 wherein at least one of one or more materials constituting the layer formed by a wet process is a low-molecular compound.
6. The method for producing an organic electroluminescent device having a cathode, an anode and one or more organic thin layers having an emitting layer, interposed between the anode and the cathode comprising:
   forming at least one layer of the organic thin layers by a wet process; and
   drying the layer formed by a wet process by heating with infrared radiation under ultrahigh vacuum.

According to the invention, even though an organic EL device comprises an organic thin layer formed by a wet process, the device can have a long luminous lifetime.
The method for producing an organic EL device of the invention enables to dry an organic thin layer formed by a wet method at low temperatures and for a short time. Furthermore, the method enables removal of the residual solvent in the organic thin layer to a high degree. Therefore, the method of the invention is effective for an enlarged screen display using an organic EL device.

### BRIEF DESCRIPTION OF DRAWINGS

FIG. 1 is a view showing an example of a spectrum indicating the relationship between measuring time and the amount of gas generated in temperature desorption spectroscopy measurement.
FIG. 2 is a schematic view of an apparatus for forming an organic layer.
FIG. 3 is a cross-sectional view showing an embodiment of an organic EL device according to the invention.

### BEST MODE FOR CARRYING OUT THE INVENTION

An organic EL device according to the invention is described below in detail.
The organic EL device of the invention comprises an anode, a cathode and one or more organic thin layers comprising an emitting layer, interposed between the anode and the cathode; and at least one layer of the organic thin layers is formed by a wet process. In the invention, the amount of the residual solvent in the layer is the detection limit (detected partial pressure of 1.0×10⁻¹² Pa) of temperature desorption spectroscopy (TDS: measured at 80°C) or less.

The temperature desorption spectroscopy is a measurement method wherein a sample is heated in a high vacuum container, the residual solvent is taken out from the sample to be gasificated when heating, and the gas is detected with a quadrupole mass spectrometer, which can measure the residual solvent contained in the sameple with a high sensitivity.
In the invention, the measuring conditions of the temperature desorption spectroscopy are that the vacuum level is 1.0 × 10⁻⁷ Pa to 9.9 × 10⁻⁷ Pa, the temperature of the sample is 80°C (fixed), and the sample is 5 millimeters square. If the maximum value of detected partial pressures of gas generated from the residual solvent is 1.0 × 10⁻¹² Pa or less, deterioration of a device caused by the residual solvent during a wet process is effectively prevented. It is preferable that the maximum value of detected partial pressures be 1.0 × 10⁻¹² Pa or less when the temperature of the sample is about 100 °C.

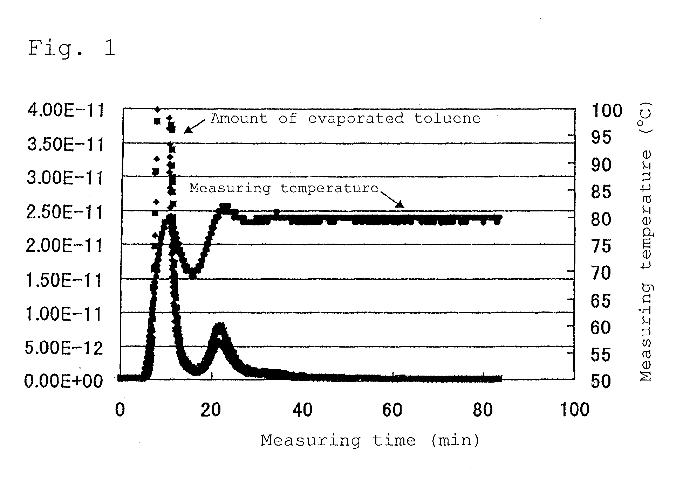

FIG. 1 is a view showing an example of a spectrum indicating the relationship between measuring time and the amount of gas generated in temperature desorption spectroscopy measurement.
In FIG. 1, the ordinate indicates the amount of generated gas (detected partial pressure: unit Pa) and the measuring temperature, and the abscissa indicates the measuring time. The measuring conditions of the invention will be described in the evaluation example mentioned later.
In this spectrum, peaks which indicate a large amount of desorbed toluene are observed in from 10 minutes to 30 minutes of the measuring time, and the generation of the toluene gas was completed after about 40 minutes.
In FIG. 1, "equal to or less than the detection limit" means the state in which the above-mentioned peaks and the like cannot be observed, or about 40 minutes lapsed (a desorped gas cannot be observed (a detected partial pressure is 1.0 × 10⁻¹² Pa or less)).

As examples of the method wherein the amount of the residual solvent in a layer formed by a wet process is the detection limit of temperature desorption spectroscopy or less, there can be given the method of the invention comprising drying a layer formed by a wet process by heating with infrared radiation under ultrahigh vacuum. The method will be described below with reference to the drawings.

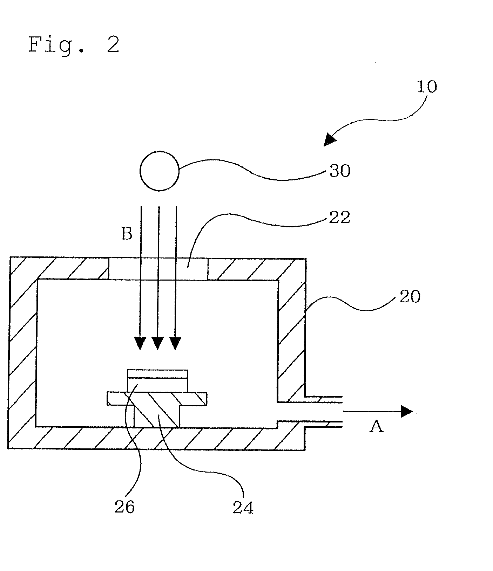

FIG. 2 is a schematic view of an apparatus for forming an organic layer.
An apparatus for forming an organic layer 10 is mainly constituted of a vacuum chamber 20, an infrared radiation generation part 30 and a vacuum pump (not shown).
The vacuum chamber 20 is an airtight container which maintains ultrahigh vacuum therein. A silica glass window 22 is provided at the upper part of the vacuum chamber 20 in order to introduce infrared radiation irradiated from the infrared radiation generation part 30 into the chamber.
A sample stage 24 inside the chamber 20 holds a sample 26 of an organic EL device comprising a layer applied by a wet process thereon. The vacuum chamber 20 is connected to the vacuum pump in order to form an ultrahigh vacuum state therein.
As these components, any members generally used on the industrial scale can be used. For example, an electromagnetic suspension type turbo pump ("TYP TURBO VAC340M" manufactured by LEYBOLD CO., LTD.) can be used as the vacuum pump, and a halogen lamp can be used as the infrared radiation generation part.

Next, a production process of an organic EL device using the apparatus for forming an organic layer 10 will be described below.
Firstly, the sample 26 comprising a layer applied by a wet process is put on the sample stage 24. Then, degassing is performed with the vacuum pump to make the interior of the chamber 20 a ultrahigh vacuum state (an arrow A indicates the degassing direction). In this state, infrared radiation, as illustrated as an arrow B, is irradiated from the infrared radiation generation part 30 to the sample 26 inside the vacuum chamber 20. The heating temperature of the sample 26 is adjusted by controlling the amount of infrared radiation. Infrared radiation may be irradiated before the interior of the chamber is made a vacuum state.
As described above, a layer formed by a wet process is heated with infrared radiation, whereby not only the surface of the layer but also the interior of the layer can be heated quickly. Therefore, even though the heating temperature is set at a relatively low temperature, the drying time of the layer can be shortened. Furthermore, the amount of the residual solvent in the layer can be reduced to the detection limit or less of temperature desorption spectroscopy by heating with infrared radiation under ultrahigh vacuum.

In the invention, the vacuum level of the ultrahigh vacuum is preferably 10⁻⁹ Pa to 10⁻⁶ Pa, and particularly preferably 10⁻⁹ Pa to 10⁻⁷ Pa. When the vacuum level is more than 10⁻⁶ Pa, the drying time may be prolonged and the solvent may not be sufficiently removed. When the vacuum level is less than 10⁻⁹ Pa, it may be difficult to maintain the vacuum state.

The heating temperature with infrared radiation is preferably equal to or less than the glass transition temperature of a material constituting the layer formed by a wet process, and particularly preferably less than the glass transition temperature of the material by 10°C or more. When the heating temperature is more than the glass transition temperature of the material, the material may be deteriorated and the emission color and the device lifetime may be affected. Although the glass transition temperature of a material varies depending on the material, the temperature is generally about 60°C to about 200°C.
The drying time of the organic thin layer is appropriately adjusted considering the thickness of the layer and the glass transition temperature of the material used. For example, the drying time is about 40 minutes at the drying temperature of 80°C in the case of the organic thin layer measured in FIG. 21.

In the method for producing an organic EL device of the invention, each layer formed by a wet process may be dried after its formation, or layers, for example a hole-injecting layer and an emitting layer, are formed and then the entire layers may be dried. In the latter case, a layer formed may be preliminarily dried before the next layer formation.

In the organic EL device of the invention, it suffices that the residual solvent of a layer formed by a wet process is removed to a high degree. A known constitution can be utilized with respect to the other constituent components. An organic EL device according to the invention is described below.

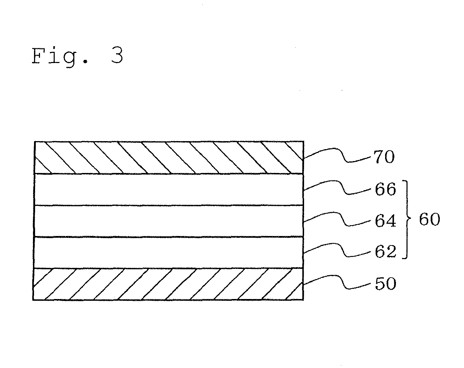

FIG. 3 is a cross-sectional view showing an embodiment of the organic EL device according to the invention.
In this organic EL device, an organic thin film layer 60 composed of a hole-injecting layer 62, an emitting layer 64, and an electron-injecting layer 66 is interposed between a cathode 70 and an anode 50.
As the representative device structure of the organic EL device of the invention, the following structures can be given.
(1) Anode/emitting layer/cathode
(2) Anode/hole-injecting layer/emitting layer/cathode
(3) Anode/emitting layer/electron-injecting layer/cathode
(4) Anode/hole-injecting layer/emitting layer/electron-injecting layer/cathode (FIG. 3)
(5) Anode/organic semiconductor layer/emitting layer/cathode
(6) Anode/organic semiconductor layer/electron-barrier layer/emitting layer/cathode
(7) Anode/organic semiconductor layer/emitting layer/adhesion-improving layer/cathode
(8) Anode/hole-injecting layer/hole-transporting layer/emitting layer/electron-injecting layer/cathode
(9) Anode/insulative layer/emitting layer/insulative layer/cathode
(10) Anode/inorganic semiconductor layer/insulative layer/emitting layer/insulative layer/cathode
(11) Anode/organic semiconductor layer/insulative layer/emitting layer/insulative layer/cathode
(12) Anode/insulative layer/hole-injecting layer/hole-transporting layer/emitting layer/insulative layer/cathode
(13) Anode/insulative layer/hole-injecting layer/hole-transporting layer/emitting layer/electron-injecting layer/cathode
   The device structure is, however, not limited to these.
Of these, normally, the structure (8) is preferably used.

In the above device, one or a plurality of layers interposed between the anode and the cathode correspond to the organic thin film layer. All of these layers are not required to be composed of an organic compound. A layer formed of or containing an inorganic compound may be included.

The organic EL device of the invention is usually formed on a transparent substrate. The transparent substrate as referred to herein is a substrate for supporting the organic EL device, and is preferably a flat and smooth substrate having a transmittance of 50% or more to light rays within visible ranges of 400 to 700 nm.
Specific examples thereof include glass plates and polymer plates. Examples of the glass plate include soda-lime glass, barium/strontium-containing glass, lead glass, aluminosilicate glass, borosilicate glass, barium borosilicate glass, and quartz. Examples of the polymer plate include polycarbonate, acrylic polymer, polyethylene terephthalate, polyethersulfide, and polysulfone.

The anode of the organic EL device of the invention plays a role for injecting holes into its hole-transporting layer or emitting layer. The anode effectively has a work function of 4.5 eV or more. Tin-doped indium tin oxide alloy (ITO), tin oxide (NESA), gold, silver, platinum, copper, and the like may be used as the material for the anode of the invention.
The anode can be formed by forming these electrode materials into a thin film by deposition, sputtering or the like.
In the case where emission from the emitting layer is outcoupled through the anode, the transmittance of the anode to the emission is preferably more than 10%. The sheet resistance of the anode is preferably several hundreds Ω/□ or less. The film thickness of the anode, which varies depending upon the material thereof, is usually from 10 nm to 1 µm, preferably from 10 to 200 nm.

The emitting layer of the organic EL device has the following functions in combination.
(i) Injecting function: function of allowing injection of holes from anode or hole-injecting layer and injection of electrons from cathode or electron-injecting layer upon application of electric field
(ii) Transporting function: function of moving injected carriers (electrons and holes) by the force of electric field
(iii) Emission function: function of providing a site for recombination of electrons and holes, leading to emission
   Note that electrons and holes may be injected into the emitting layer with different degrees, or the transportation capabilities indicated by the mobility of holes and electrons may differ. It is preferable that the emitting layer move one of carriers.

As the method of forming the emitting layer, a known method such as deposition, spin coating, or an LB method may be applied. The emitting layer may also be formed by dissolving a binder such as a resin and a material compound in a solvent to obtain a solution, and forming a thin film from the solution by spin coating or the like, as disclosed in JP-A-57-51781.

In the organic EL device of the invention, it is preferred that the emitting layer be composed of a host compound and a dopant. The host compound transports at least one of carriers; namely, electrons or holes. Preferred examples of the host compounds include known carbazole derivatives, compounds with an anthracene skeleton, and compounds with a condensed heterocyclic skeleton having a nitrogen atom. The host compound may be a high-molecular compound. As the high-molecular compounds used as the host, a monomer, an oligomer such as a dimer and a trimer, which contains carbazole, and a high-molecular compound having a carbazole group can be given.

The emitting layer may contain a fluorescent or a phosphorescent dopant.
As the fluorescent dopant, a styrylamine compound represented by the following formula (1) or an arylamine compound represented by the following formula (2) can be used.

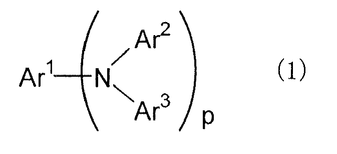

wherein Ar¹ is a group selected from phenyl, biphenyl, terphenyl, stilbene and distyrylaryl, Ar² and Ar³ are independently a hydrogen atom or an aromatic group having 6 to 20 carbon atoms, and p is an integer of 1 to 4 and Ar¹ to Ar³ may be substituted. More preferably, Ar² and/or Ar³ are substituted by a styryl group.

As the aromatic group having 6 to 20 carbon atoms, phenyl, naphthyl, anthranyl, phenanthryl, and terphenyl are preferable. 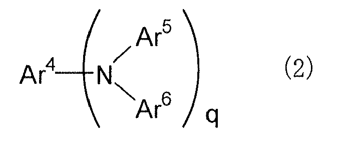 wherein Ar⁴ to Ar⁶ are a substituted or unsubstituted aryl group having 5 to 40 nucleus atoms. q is an integer of 1 to 4.

As the aryl group having 5 to 40 nucleus atoms, phenyl, naphthyl, anthranyl, phenanthryl, pyrenyl, cholonyl, biphenyl, terphenyl, pyrolyl, furanyl, thiophenyl, benzothiophenyl, oxadiazolyl, diphenylantranyl, indolyl, carbazolyl, pyridyl, benzoquinolyl, fluoranthenyl, acenapthofluoranthenyl, stilbene, or the like are preferable. The aryl group having 5 to 40 nucleus atoms may be substituted with a substituent. Examples of the preferred substituent include an alkyl group having 1 to 6 carbon atoms (ethyl, methyl, i-propyl, n-propyl, s-butyl, t-butyl, pentyl, hexyl, cyclopentyl, cyclohexyl, or the like); an alkoxy group having 1 to 6 carbon atoms (ethoxy, methoxy, i-propoxy, n-propoxy, s-buthoxy, t-buthoxy, penthoxy, hexyloxy, cyclopentoxy, cyclohexyloxy, or the like); an aryl group having 5 to 40 nucleus atoms; an amino group substituted with an aryl group having 5 to 40 nucleus atoms; an ester group with an aryl group having 5 to 40 nucleus atoms; an ester group with an alkyl group having 1 to 6 carbon atoms; a cyano group; a nitro group; and a halogen atom (chlorine, bromine, iodine, or the like).

The phosphorous dopant is preferably a metal complex containing at least one metal selected from iridium (Ir), ruthenium (Ru), palladium (Pd), platinum (Pt), osmium (Os) and rhenium (Re). The ligand preferably has at least one skeleton selected from phenylpyridine, bipyridyl, and phenanthroline. Specific examples of such metal complex include, but not limited to, tris(2-phenylpyridine)iridium, tris(2-phenylpyridine)ruthenium, tris(2-phenylpyridine)palladium, bis(2-phenylpyridine)platinum, tris(2-phenylpyridine)osmium, tris(2-phenylpyridine)rhenium, platinum octaethyl porphyrin, platinum octaphenyl porphyrin, palladium octaethyl porphyrin, and palladium octaphenyl porphyrin. A suitable complex is selected according to a required color of emitted light, device performance, and a relationship with a host compound.

The hole-injecting/transporting layer of the organic EL device according to the invention is a layer for helping the injection of holes into the emitting layer to transport the holes to a light-emitting region. The hole mobility thereof is large and the ionization energy thereof is usually as small as 5.5 eV or less. Such a hole-injecting/transporting layer is preferably made of a material which can transport holes to the emitting layer at a lower electric field intensity. The hole mobility thereof is preferably at least 10⁻⁴ cm²/V·second when an electric field of, e.g., 10⁴ to 10⁶ V/cm is applied.

Any materials which have the above preferable properties can be used as the material for forming the hole-injecting/transporting layer without particular limitation. The material for forming the hole-injecting/transporting layer can be arbitrarily selected from materials which have been widely used as a material transporting carriers of holes in photoconductive materials and known materials used in a hole-injecting layer of organic EL devices. For example, an aromatic tertiary amine, a hydrazone derivative, a carbazole derivative, a triazole derivative, an imidazole derivative, polyvinyl carbozole, polyethylene dioxythiophene/polysulfonic acid (PEDOT/PSS) or the like can be given. Specific examples include triazole derivatives (see USP No. 3, 112, 197 and others), oxadiazole derivatives (see USP No. 3,189,447 and others), imidazole derivatives (see JP-B-37-16096 and others), polyarylalkane derivatives (see USP Nos. 3,615,402, 3,820,989 and 3,542,544, JP-B-45-555 and 51-10983, JP-A-51-93224, 55-17105, 56-4148, 55-108667, 55-156953 and 56-36656, and others), pyrazoline derivatives and pyrazolone derivatives (see USP Nos. 3,180,729 and 4,278,746, JP-A-55-88064, 55-88065, 49-105537, 55-51086, 56-80051, 56-88141, 57-45545, 54-112637 and 55-74546, and others), phenylene diamine derivatives (see USP No. 3,615,404, JP-B-51-10105, 46-3712 and 47-25336, JP-A-54-53435, 54-110536 and 54-119925, and others), arylamine derivatives (see USP Nos. 3,567,450, 3,180,703, 3,240,597, 3,658,520, 4,232,103, 4,175,961 and 4,012,376, JP-B-49-35702 and 39-27577, JP-A-55-144250, 56-119132 and 56-22437, DE1,110,518, and others), amino-substituted chalcone derivatives (see USP No. 3, 526, 501, and others), oxazole derivatives (ones disclosed in USP No. 3,257,203, and others), styrylanthracene derivatives (see JP-A-56-46234, and others), fluorenone derivatives (JP-A-54-110837, and others), hydrazone derivatives (see USP Nos. 3,717,462, JP-A-54-59143, 55-52063, 55-52064, 55-46760, 55-85495, 57-11350, 57-148749 and 2-311591, and others), stilbene derivatives (see JP-A-61-210363, 61-228451, 61-14642, 61-72255, 62-47646, 62-36674, 62-10652, 62-30255, 60-93455, 60-94462, 60-174749 and 60-175052, and others), silazane derivatives (USP No. 4,950,950), polysilanes (JP-A-2-204996), aniline copolymers (JP-A-2-282263), and electroconductive high-molecular oligomers (in particular thiophene oligomers) disclosed in JP-A-1-211399.

The above-mentioned substances can be used as the material of the hole-injecting layer. The following can also be used: porphyrin compounds, aromatic tertiary amine compounds and styrylamine compounds (see USP No. 4, 127, 412, JP-A-53-27033, 54-58445, 54-149634, 54-64299, 55-79450, 55-144250, 56-119132, 61-295558, 61-98353 and 63-295695, and the like). In particular, aromatic tertiary amine compounds may preferably be used.

The following can also be given as examples: 4,4'-bis(N-(1-naphthyl)-N-phenylamino)biphenyl (abbreviated as "NPD" hereinafter), which has in the molecule thereof two condensed aromatic rings, disclosed in USP No. 5,061,569, and 4,4',4"-tris(N-(3-methylphenyl)-N-phenylamino)triphenylamin e (abbreviated as "MTDATA", hereinafter), wherein three triphenylamine units are linked to each other in a star-burst form, disclosed in JP-A-4-308688.
The aromatic dimethylidene type compounds as mentioned above as the material for an emitting layer, and inorganic compounds such as p-type Si and p-type SiC can be used as the material for the hole-injecting layer.

The hole-injecting/transporting layer can be formed from the above-mentioned compounds by a known method such as vacuum deposition, spin coating, casting or LB technique. The film thickness of the hole-injecting/transporting layer is not particularly limited, and is usually from 5 nm to 5 µm. This hole-injecting/transporting layer may be a single layer made of one or two or more of the above-mentioned materials, or may be stacked hole-injecting/transporting layers made of compounds different.

In the organic EL device of the invention, the organic semiconductor layer is a layer for helping the injection of holes or electrons into the emitting layer, and is preferably a layer having an electric conductivity of 10⁻¹⁰ S/cm or more. As the material of such an organic semiconductor layer, electroconductive oligomers such as thiophene-containing oligomers or arylamine-containing oligomers disclosed in JP-A-8-193191, and electroconductive dendrimers such as arylamine-containing dendrimers may be used.

In the organic EL device of the invention, the electron-injecting layer is a layer which assists injection of electrons into the emitting layer, and exhibits a high electron mobility. An adhesion-improving layer is formed of a material which exhibits particularly excellent adhesion to the cathode among the electron-injecting layers. The material used in the electron-injecting layer is preferably a metal complex of 8-hydroxyquinoline or a derivative thereof, or an oxadiazole derivative.

As specific examples of a metal complex of 8-hydroxyquinoline and an 8-hydroxyquinoline derivative, metal chelate oxinoid compounds including a chelate of oxine (usually, 8-quinolinol or 8-hydroxyquinoline) can be given. For example, tris(8-quinolinol)aluminum (Alq) may be used in the electron-injecting layer.
An electron-transporting compound of the following general formula can be given as the oxadiazole derivative.

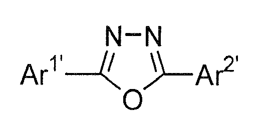

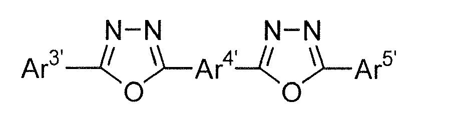

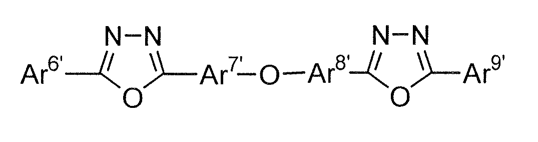

wherein Ar^{1'}, Ar^{2'}, Ar^{3'}, Ar^{5'}, Ar^{6'} and Ar^{9'} are individually a substituted or unsubstituted aryl group and may be the same or different; and Ar^{4'}, Ar^{7'} and Ar^{8'} are a substituted or unsubstituted arylene group and may be the same or different.
As examples of the aryl group, a phenyl group, a biphenyl group, an anthranyl group, a perylenyl group, and a pyrenyl group can be given. As examples of the arylene group, a phenylene group, a naphthylene group, a biphenylene group, an anthranylene group, a perylenylene group, a pyrenylene group, and the like can be given. As the substituent, an alkyl group having 1 to 10 carbon atoms, an alkoxy group having 1 to 10 carbon atoms, a cyano group, and the like can be given. The electron-transporting compound is preferably one from which a thin film can be formed.

The following compounds can be given as specific examples of the electron-transporting compound. 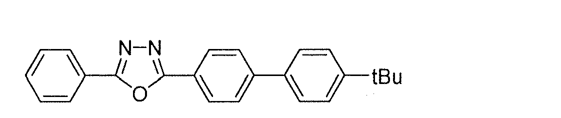 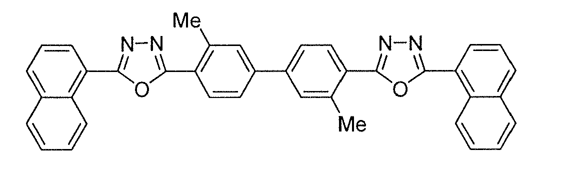 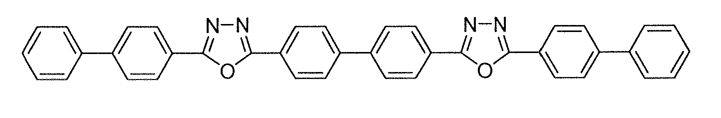 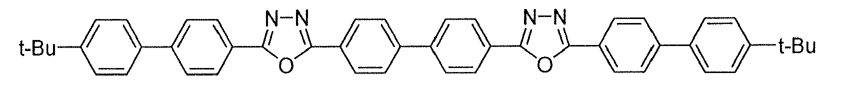 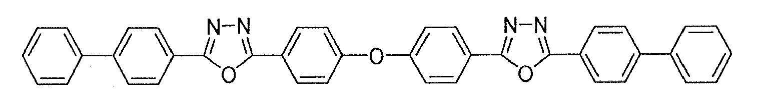 In the formula, Me is methyl and Bu is butyl.

A preferred embodiment of the organic EL device of the invention is a device containing a reducing dopant in an electron-transporting region or an interfacial region between the cathode and the organic thin film layer. The reducing dopant is defined as a substance which can reduce an electron-transferring compound. Accordingly, various substances which have certain reducing properties can be used. For example, at least one substance can be preferably used which is selected from the group consisting of alkali metals, alkaline earth metals, rare earth metals, alkali metal oxides, alkali metal halides, alkaline earth metal oxides, alkaline earth metal halides, rare earth metal oxides, rare earth metal halides, alkali metal organic complexes, alkaline earth metal organic complexes, and rare earth metal organic complexes.

More specifically, preferable reducing agents include at least one alkali metal selected from Na (work function: 2.36 eV), K (work function: 2.28 eV), Rb (work function: 2.16 eV) and Cs (work function: 1.95 eV) ; and at least one alkaline earth metal selected from Ca (work function: 2.9 eV), Sr (work function: 2.0 to 2.5 eV) and Ba (work function: 2.52 eV). A substance having a work function of 2.9 eV or less is particularly preferable.

Among these, a more preferable reducing dopant is at least one alkali metal selected from the group consisting of K, Rb and Cs. Even more preferable is Rb or Cs. Most preferable is Cs. These alkali metals are particularly high in reducing ability. Thus, the addition of a relatively small amount thereof to an electron-injecting zone improves the luminance of the organic EL device and make the lifetime thereof long. As the reducing dopant having a work function of 2.9 eV or less, a combination of two or more out of these alkali metals is also preferred. Particularly preferred is a combination containing Cs, for example, combinations of Cs and Na, Cs and K, Cs and Rb, or Cs, Na and K. The combination containing Cs makes it possible to exhibit the reducing ability efficiently. The luminance of the organic EL device can be improved and the lifetime thereof can be made long by the addition thereof to its electron-injecting zone.

In the organic EL device, an electron-injecting layer made of an insulator or a semiconductor may further be provided between a cathode and an organic thin film layer. By providing the layer, current leakage can be effectively prevented to improve the injection of electrons.
As the insulator, at least one metal compound selected from the group consisting of alkali metal calcogenides, alkaline earth metal calcogenides, halides of alkali metals and halides of alkaline earth metals can be preferably used. When the electron-injecting layer is formed of the alkali metal calcogenide or the like, the injection of electrons can be preferably further improved. Specifically preferable alkali metal calcogenides include Li₂O, LiO, Na₂S, Na₂Se and NaO and preferable alkaline earth metal calcogenides include CaO, BaO, SrO, BeO, BaS and CaSe. Preferable halides of alkali metals include LiF, NaF, KF, LiCl, KCl and NaCl. Preferable halides of alkaline earth metals include fluorides such as CaF₂, BaF₂, SrF₂, MgF₂ and BeF₂ and halides other than fluorides.

Examples of the semiconductor include oxides, nitrides or oxynitrides containing at least one element selected from Ba, Ca, Sr, Yb, Al, Ga, In, Li, Na, Cd, Mg, Si, Ta, Sb and Zn, and combinations of two or more thereof. An inorganic compound forming an electron-transporting layer is preferably a microcrystalline or amorphous insulating thin film. When the electron-transporting layer is formed of the insulating thin films, more uniformed thin film is formed whereby pixel defects such as a dark spot are decreased. Examples of such an inorganic compound include the above-mentioned alkali metal calcogenides, alkaline earth metal calcogenides, halides of alkali metals, and halides of alkaline earth metals.

For the cathode of the organic EL device of the invention, in order to inject electrons to an electron-transporting layer or emitting layer, the following electrode substance may be used: metals, alloys or electroconductive compounds, or mixtures thereof which have a small work function (4 eV or less). Specific examples of the electrode substance include sodium, sodium-potassium alloys, magnesium, lithium, magnesium/silver alloys, aluminum/aluminum oxide, aluminum/lithium alloys, indium, and rare earth metals.
This cathode can be formed by making the electrode substances into a thin film by deposition, sputtering or some other method. In the case where emission from the emitting layer is outcoupled through the cathode, it is preferred to make the transmittance of the cathode to the emission larger than 10%. The sheet resistance of the cathode is preferably several hundreds Ω/□ or less, and the film thickness thereof is usually from 10 nm to 1 µm, preferably from 50 to 200 nm.

In the organic EL device of the invention, pixel defects based on leakage or a short circuit are easily generated since an electric field is applied to the super thin film. In order to prevent this, it is preferred to insert an insulative thin layer between the pair of electrodes.
Examples of the material used in the insulative layer include aluminum oxide, lithium fluoride, lithium oxide, cesium fluoride, cesium oxide, magnesium oxide, magnesium fluoride, calcium oxide, calcium fluoride, cesium fluoride, aluminum nitride, titanium oxide, silicon oxide, germanium oxide, silicon nitride, boron nitride, molybdenum oxide, ruthenium oxide, and vanadium oxide. A mixture or laminate thereof may be used.

The film thickness of each of the organic thin film layers in the organic EL device of the invention is not particularly limited. In general, defects such as pinholes are easily generated when the film thickness is too small. Conversely, a high applied voltage becomes necessary, leading to low efficiency, when the film thickness is too large. Usually, therefore, the film thickness is preferably in the range of several nanometers to one micrometer.

By the method and materials exemplified above, an anode and an organic thin film layer such as an emitting layer are formed, followed by formation of a cathode, whereby an organic EL device can be fabricated. The organic EL device can be fabricated in the order reverse to the above, i.e., the order from a cathode to an anode.

In the organic EL device of the invention, at least one of the above-mentioned organic thin film layers is formed by a wet process.
When a device is fabricated by a wet process, a solution prepared by dissolving in an organic solvent a material for constituting the organic thin film layer is used.
Examples of the solvent for preparing the solution include an alcohol-based solvent such as methanol, ethanol, propanol, isopropanol, n-butanol, t-butanol, pentanol, hexanol, cyclohexanol, methyl cellosolve, ethyl cellosolve, ethylene glycol; a halogenated hydrocarbon-based solvent such as dichloromethane, dichloroethane, chloroform, carbon tetrachloride, tetrachloroethane, trichloroethane, chlorobenzene, dichlorobenzene, and chlorotoluene; an ether-based solvent such as dibutyl ether tetrahydofuran, dioxane, and anisole; an aromatic solvent such as benzene, toluene, xylene, and ethyl benzene; a paraffin-based solvent such as hexane, octane, decane, and tetralin; an ester-based solvent such as ethyl acetate, butyl acetate, and amyl acetate; an amide-based solvent such as N,N-dimethylformamide, N,N-dimethylacetoamide, and N-methylpyrrolidinone; a ketone-based solvent such as acetone, methyl ethyl ketone, cyclohexanone, and isophorone; an amine-based solvent such as pyridine, quinoline, and aniline; a nitrile-based solvent such as acetonitrile and valeronitrile; and a sulfur-based solvent such as thiophene and carbon disulfide. The usable solvents are not limited to these. For example, water may be used.

As for the solution of the material constituting a layer, it is preferred that the material be dissolved at a concentration of 0.1 wt%. In various device structures, the thickness of an emitting layer in an organic EL device is normally 10 to 100 nm. The common thickness of the emitting layer is 50 nm. When forming a layer with such a thickness, it is desired that the material be dissolved at a concentration of 0.1 wt% or more. If the concentration is less than 0.1 wt%, an organic thin film layer with a sufficient thickness cannot be obtained. In addition, troubles such as lowering of performance and significant divergence of the color tone may occur. A preferred concentration of the coating solution is 0.1 wt% or more. To form a layer with a common thickness of 50 nm, it is preferred that the solution concentration be 0.5 wt% or more.

An organic thin film layer can be formed by applying the solution of the material constituting a layer to an intended site by spin coating, inkjet, or the like, followed by drying.
It is preferred that a low-molecular compound be used as at least one of the materials for forming the organic thin film layer. Due to the presence of a low-molecular compound in the organic thin film layer, the solvent is readily evaporated when drying the organic thin film layer, whereby the drying time can be shortened and the drying temperature can be set at low. The low-molecular compound as referred to herein means a compound with a molecular weight of 10,000 or less, preferably 3,000 or less.

As the low-molecular compound, an anthracene compound or a pyrene compound described in PCT/JP03/10402, PCT/JP2004/018111, and Japanese Patent Application No. 2004-157571. These compounds can be preferably used as a host material of the emitting layer.

### EXAMPLES

### Example 1

A grass substrate of 25 mm by 75 mm by 1.1 mm thick with an ITO transparent electrode (GEOMATEC CO., LTD.) was subjected to ultrasonic cleaning with isopropyl alcohol for 5 minutes, and cleaned with ultraviolet rays and ozone for 30 minutes.
On the surface of the cleaned glass substrate where the transparent electrode is formed, using an aqueous solution of polyethylenedioxythiophene/polystyrenesulfonate (PEDOT/PSS, Tg: 230°C), a 30 nm-thick thin film of PEDOT/PSS was formed.

Then, under vacuum with a vacuum level of 10⁻⁷ Pa, the substrate was dried for 40 minutes after heating the substrate to 100°C using an infrared radiation heating source (halogen lamp). The PEDOT/PSS thin film thus prepared functioned as a hole-injecting layer.
The film thus prepared was analyzed by temperature desorption spectroscopy (temperature desorption spectroscopy apparatus: EMD-WA1000S manufactured by ESCO, Ltd.). As a result, it was found that the moisture in the film was removed to the detection limit (a detected partial pressure: 1.0 × 10⁻¹² Pa) or less. The measurement was performed under conditions of 100°C and 10⁻⁷ Pa.
The measurement was performed using a measurement sample which had been cut into 5 millimeters square.

Subsequently, a 20-nm thick N,N,N',N'-tetrakis(4-biphenyl)-4,4'-benzidine (BPTPD) film was formed by deposition thereon. The BPTPD film functioned as a hole-transporting layer. Further, the following compound (A) and the following doping material (PAVB) were co-deposited on the BPTPD film at a deposition speed ratio of 40:2 to form a film with a thickness of 40 nm. The film functioned as an emitting layer.
As an electron-transporting layer, a 10 nm-thick tris(hydroxyquinoline)aluminum film (Alq shown below) was formed thereon. This Alq film functioned as an electron-transporting layer.
Then, Li as a reducing dopant (Li source: manufactured by SAES Getters CO., LTD.) and Alq were co-deposited, whereby an Alq:Li film (film thickness: 10 nm) was formed as an electron-injecting layer (cathode).
Al was deposited on the Alq:Li film to form a metal cathode, thereby fabricating an organic EL device.

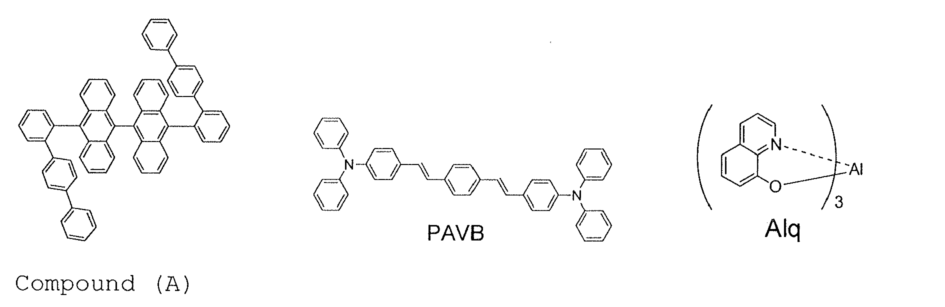

When a DC voltage of 5 V was applied to the device, a current with a density of 1.2 mA/cm² flowed and blue emission with a luminance of 99 cd/m² was observed. At that time, the CIE coordinates were (0.15, 0.29), and a luminescent efficiency was 8.2 cd/A and 5.3 1m/W. The half life of luminance from 500 cd/m² was measured and found to be 3,000 hours.

### Comparative Example 1

An organic EL device was fabricated in the same manner as in Example 1, except that the PEDOT/PSS thin film was formed according to the following method.

### [Formation of PEDOT/PSS thin film]

A 30 nm-thick PEDOT/PSS thin film was formed by spin coating using an aqueous solution of polyethylenedioxythiophene/polystyrenesulfonate (PEDOT/PSS). Thereafter, the film was dried for two hours on a hot plate at a substrate temperature of 200°C, whereby a PEDOT/PSS film was formed.
The film thus prepared was analyzed by temperature desorption spectroscopy. It was found that the maximum detected partial pressure of water was 1.0 × 10⁻⁶ Pa.

An electric current was applied to the device to cause the device to emit light. A lot of dark spots were generated on the emitting surface. In this device, a current with a density of 1.2 mA/cm² flowed at a DC voltage of 7 V, and blue emission with a luminance of 60 cd/m² was observed. At that time, the CIE coordinates were (0.15, 0.29), and luminescent efficiency was 5. 0 cd/A and 2. 3 lm/W. The half life of luminance from 500 cd/m² was measured and found to be 500 hours.
The generation of the dark spots is considered to be caused by the residual moisture in the PEDOT/PSS film due to insufficient drying of the film by heating on the hot plate.

### Example 2

A grass substrate of 25 mm by 75 mm by 1.1 mm thick with an ITO transparent electrode (GEOMATEC CO., LTD.) was subjected to ultrasonic cleaning with isopropyl alcohol for 5 minutes, and cleaned with ultraviolet rays and ozone for 30 minutes.
The cleaned glass substrate having the transparent electrode lines was then secured to a substrate holder of an apparatus for vacuum deposition. First, a 40-nm thick N,N'-bis(4-diphenylaminophenyl)-N,N'-diphenyl-4,4'-diaminob iphenyl film (TPD 232 film) was formed on the surface on which the transparent electrode lines were formed so as to cover the transparent electrodes. This TPD232 film functioned as a hole-injecting layer.
Subsequently, a 40 nm-thick N,N,N',N'-tetrakis(4-biphenyl)-4,4'-bendizine film (BPTPD film) was formed on the TPD 232 film by vacuum deposition. This BPTPD film functioned as a hole-transporting layer.

Subsequently, 9,10-bis(3-(1-naphthyl)phenyl)-2-(2-biphenyl)anthracene (Tg: 130°C) and 1, 6-bis (diphenylamino) pyrene were dissolved at a weight ratio of 20: 1 in a mixed solvent of dioxane and isopropyl alcohol (volume ratio: 1:8), whereby a 3 wt% coating solution was prepared.
Using this coating solution, a 40 nm-thick emitting layer was formed by spin coating on the above-prepared BPTPD film.
Then, under vacuum with a vacuum level of 10⁻⁶ Pa, the substrate was heated so that the substrate temperature became 120°C using an infrared radiation heating source (halogen lamp), followed by drying for 30 minutes.
The film thus prepared was analyzed by temperature desorption spectroscopy. It was found that the residual solvent was removed to the detection limit or less.

Subsequently, the substrate was moved to a vacuum deposition apparatus using a substrate transporter without exposing the substrate to air. A 30 nm-thick tris(8-hydroxyquinoline)aluminum (Alq) was formed by vacuum deposition. This Alq film functioned as an electron-transporting layer.
Further, a lithium fluoride film with a 1 nm thickness was formed by vacuum deposition as an electron-injecting layer.
Lastly, an aluminum cathode was formed by vacuum deposition, whereby an organic EL device was fabricated.

A voltage of 5.0 V was applied to this device. A current with a density of 2.5 mA/cm² flowed and blue emission with a luminance of 92 cd/m² was obtained at CIE coordinates of (0.15, 0.26). The luminescent efficiency was 3.7 cd/A and 2.3 lm/W. The device was driven at a constant current at room temperature. It was found that the half life of luminance from 100 cd/m² was 10,800 hours.

### Comparative Example 2

An organic EL device was fabricated in the same manner as in Example 2, except that the emitting layer was formed according to the following method.

### [Formation of emitting layer]

A 40 nm-thick emitting layer was formed by spin coating on the BPTPD previously film formed using the same coating solution as that used in Example 2. The substrate was heated to dry at 120°C for 30 minutes on a hot plate, whereby an emitting layer was formed.

A voltage of 5.0 V was applied to this device. A current with a density of 2.5 mA/cm² flowed and blue emission with a luminance of 92 cd/m² was obtained at CIE coordinates of (0.15, 0.26). The luminescent efficiency was 3.7 cd/A and 2.3 1m/W. The device was driven at a constant current at room temperature. It was found that the half life of luminance from 100 cd/m² was 2, 600 hours. The reason for such a short lifetime of the device is considered to be caused by the residual solvent in the emitting layer.

### Comparative Example 3

An organic EL device was fabricated in the same manner as in Example 2, except that drying of the emitting layer was performed on a hot plate at 140°C for 30 minutes.
A voltage of 8.0 V was applied to this device. A current with a density of 2.5 mA/cm² flowed and blue emission with a luminance of 42 cd/m² was obtained at CIE coordinates of (0.27, 0.48). The luminescent efficiency was 1.7 cd/A and 0.7 lm/W. The device was driven at a constant current at room temperature. It was found that the half life of luminance from 100 cd/m² was 5,300 hours.

The lifetime of this device was longer than that of the device fabricated in Example 1. The reason therefor is considered to be a decreased amount of the residual solvent in the emitting layer. However, since heating was performed at a temperature equal to or higher than the Tg of the emitting material (9,10-bis(3-(1-naphthyl)phenyl)-2-(2-biphenyl)anthracene), the chromaticity of the emitted light was changed due to heat deterioration of the emitting material. Therefore, the device was not practically usable.
It was confirmed that the device performance deteriorated due to heat deterioration of the material if drying of the coating film was performed at too high temperatures to remove the residual solvent.

### Evaluation Example

A grass substrate of 5 mm by 5 mm by 1 mm thick was subjected to ultrasonic cleaning with isopropyl alcohol for 5 minutes, and cleaned with ultraviolet rays and ozone for 30 minutes. The substrate was secured to a spin coater (manufactured by Active Corporation). A 40 nm-thick thin film was formed by applying on the substrate an aqueous 1 wt% toluene solution of the above-mentioned compound A.
Thereafter, the temperature desorption process of the toluene in the coating film was analyzed using a temperature desorption spectroscopy apparatus (EMD-WA1000S, manufactured by ESCO, LTD.).
The measuring conditions for the apparatus are as follows. The thin film was heated to 80°C under a vacuum of 10⁻⁷ Pa. The temperature desorption process of the toluene solvent, i.e., the process for the removal of the residual toluene in the thin film, was analyzed using a quadrupole mass spectrometer (M/z=91,92). FIG. 1 shows a spectrum indicating the relationship between measuring time and the amount of gas generated (detected partial pressure: Pa). In FIG. 1, in the ordinate, "E-11" means "×10⁻¹¹" and "E-12" means "×10⁻¹²".

From FIG. 1, it was confirmed that desorption of the residual toluene in the thin film was completed by heating for about 40 minutes. It means that drying of the coating film (removal of the residual solvent) was completed by heating at 80°C for 40 minutes under a vacuum level of 10⁻⁷ Pa.

### INDUSTRIAL APPLICABILITY

The organic EL device of the invention can have a prolonged luminous lifetime even if it contains an organic thin film layer formed by a wet method. According to the method for producing an organic EL device of the invention, a material constituting an organic thin film layer is prevented from being deteriorated since a residual solvent in an organic thin film layer formed by a wet method can be removed to a high degree, and drying treatment can be performed at low temperatures for a short time.
Thus, the invention is an effective technology to realize a display with an enlarged screen using an organic EL device.

## Claims

1. An organic electroluminescent device comprising:
an anode,
a cathode, and
one or more organic thin layers comprising an emitting layer, interposed between the anode and the cathode;
at least one layer of the organic thin layers being formed by a wet process; and the residual solvent of the layer being the detection limit (a detected partial pressure of 1.0×10⁻¹² Pa) of temperature desorption spectroscopy (TDS: measured at 80°C) or less.

2. The organic electroluminescent device according to claim 1 wherein the layer formed by a wet process is a layer dried by heating with infrared radiation under ultrahigh vacuum.

3. The organic electroluminescent device according to claim 2 wherein the vacuum level of the ultrahigh vacuum is 10⁻⁹ Pa to 10⁻⁶ Pa, and the heating temperature with infrared radiation is equal to or less than the glass transition temperature of a material constituting the layer formed by a wet process.

4. The organic electroluminescent device according to claim 2 wherein the vacuum level of the ultrahigh vacuum is 10⁻⁹ Pa to 10⁻⁷ Pa, and the heating temperature with infrared radiation is less than the glass transition temperature of a material constituting the layer formed by a wet process by 10°C or more.

5. The organic electroluminescent device according to any one of claims 1 to 4 wherein at least one of one or more materials constituting the layer formed by a wet process is a low-molecular compound.

6. The method for producing an organic electroluminescent device having a cathode, an anode and one or more organic thin layers having an emitting layer, interposed between the anode and the cathode comprising:
forming at least one layer of the organic thin layers by a wet process; and
drying the layer formed by a wet process by heating with infrared radiation under ultrahigh vacuum.
